# EUROPEAN PATENT APPLICATION

(11) **EP 4 582 568 A1**
(43) Date of publication of application: **09.07.2025**
(21) Application number: 23871319.2
(22) Date of filing: 14.06.2023
(51) Int. Cl.: C21D 8/12, C22C 38/00, C22C 38/60, H01F 1/147

(54) **ORIENTED ELECTROMAGNETIC STEEL SHEET AND MANUFACTURING METHOD THEREOF, AND IRON CORE FOR TRANSFORMER**

(30) Priority: 28.09.2022 JP 2022155595
(71) Applicant: JFE Steel Corporation, Tokyo 100-0011 (JP)
(72) Inventor: OMURA,Takeshi, Tokyo 100-0011 (JP); ICHIHARA,Yoshihisa, Tokyo 100-0011 (JP); INOUE, Hirotaka, Tokyo 100-0011 (JP)
(74) Representative: Haseltine Lake Kempner LLP
(86) International application number: PCT/JP2023/022144
(87) International publication number: WO 2024/070074

(57) **Abstract**

Provided is a grain-oriented electrical steel sheet capable of effectively suppressing the generation of excitation inrush current when used as transformer iron core material. In a grain-oriented electrical steel sheet subjected to magnetic domain refining, when magnetization varying with a sine wave at 50 Hz is generated in the rolling direction of the grain-oriented electrical steel sheet and power supply is cut off when the magnetization reaches 1.50 T, then cutoff residual magnetic flux density Br, which is the magnetic flux density 0.1 s after the cut off, is 1.00 T or less.

## Description

### TECHNICAL FIELD

The present disclosure relates to a grain-oriented electrical steel sheet, a method of producing same, and an iron core for a transformer using the grain-oriented electrical steel sheet, in order to obtain a transformer that generates a small excitation inrush current when powered on.

### BACKGROUND

When designing transformers, one of the control factors that needs to be considered is excitation inrush current.

Excitation inrush current is transient excitation current that occurs at the moment a voltage is applied to a transformer in a non-excited state, such as at the moment a transformer is powered on, or when a momentary voltage drop or a momentary power failure occurs, and the amount of excitation current can reach some times to some tens of times the rated current. Even though only a momentary transient current, such a large current can cause equipment to malfunction and lead to large-scale problems such as emergency shutdowns.

Therefore, in order to deal with excitation inrush current, various AC filtering equipment such as I) transformer protection relays, II) overcurrent relays for receiving current, III) high-voltage current-limiting fuses, and IV) phase lead capacitors need to be installed, which increases costs. Accordingly, there is a great need to decrease the amount of excitation inrush current.

Further, it is known that such excitation inrush current is largely caused by "residual magnetic flux" and "voltage phase angle" when powering on a transformer. That is, controlling voltage phase angle can decrease excitation inrush current (see Patent Literature (PTL) 1).

### CITATION LIST

### Patent Literature

PTL 1: WO 2010/035778 A1

### SUMMARY

### (Technical Problem)

Although controlling the voltage phase angle can decrease the excitation inrush current, such control requires complex control and new ancillary equipment. Therefore, such a method still causes disadvantages such as increased costs and larger equipment.

In view of the above circumstances, it would be helpful to provide a grain-oriented electrical steel sheet capable of decreasing residual magnetic flux in a transformer iron core, a method of producing same, and an iron core for a transformer using the grain-oriented electrical steel sheet.

### (Solution to Problem)

The inventors conducted extensive studies into solutions to address the problem described above.

The main cause of excitation inrush current is residual magnetic flux in the iron core, and therefore the inventors thought that excitation inrush current might be controllable by controlling residual magnetic flux properties of the grain-oriented electrical steel sheets themselves, which make up the iron core. Therefore, the inventors conducted a detailed study of the relationship between residual magnetic flux density of the grain-oriented electrical steel sheet itself and excitation inrush current.

In addition, transformers are required to have low loss. Accordingly, in this study, the inventors decided to use 0.23 mm thick low iron loss material that has been subjected to magnetic domain refining treatment by a laser. Ten types of coils each having different laser irradiation conditions were prepared. The laser irradiation was tested to check various combinations of I) output, II) deflection speed, and III) beam diameter.

Subsequently, two 45° bends were made at each corner for each grain-oriented electrical steel sheet of the ten types of coils, using a Unicore Machine from AEM Cores Pty Ltd. Further, ten types of single-phase coil iron core were fabricated using grain-oriented electrical steel sheets having such bends, each single-phase iron core having a height of 250 mm × a width of 250 mm × a sheet width of 100 mm and a total mass of approximately 20 kg.

First, steady-state operation was performed with such a single-phase coil iron core at a frequency of 50 Hz and magnetic flux density of 1.70 T to measure steady-state primary-side current values. This is hereinafter referred to as steady-state current.

Next, the excitation power supply was cut off at a timing when the magnetic flux density in the iron core reached 1.70 T. The power supply was turned on again with a phase shift of 180° from when the power supply was cut off, at which point excitation inrush current is greatest, and the excitation inrush current occurring at that time, which was the primary-side current value, was evaluated. The steady-state current and the excitation inrush current were measured by a current sensor attached to the primary winding.

The evaluation results for each single-phase coil iron core are listed in Table 1.

### [Table 1]

**Table 1**

| Transformer No. | Laser irradiation conditions | | | Excitation inrush current/steady-state current ratio |
|---|---|---|---|---|
| | Output [W] | Deflection rate [m/s] | Beam diameter [mm] | |
| 1 | 50 | 5 | 0.05 | 25 |
| 2 | 50 | 40 | 0.18 | 60 |
| 3 | 100 | 30 | 0.38 | 120 |
| 4 | 100 | 30 | 0.11 | 60 |
| 5 | 200 | 40 | 0.09 | 35 |
| 6 | 100 | 100 | 0.05 | 90 |
| 7 | 100 | 10 | 0.05 | 18 |
| 8 | 150 | 100 | 0.22 | 50 |
| 9 | 300 | 150 | 0.13 | 40 |
| 10 | 300 | 100 | 0.19 | 70 |

As indicated in Table 1, the ratio of the excitation inrush current to the steady-state current changed under different laser irradiation conditions, suggesting that strain introduction state affected the excitation inrush current.

Next, the residual magnetic flux density of each of the grain-oriented electrical steel sheets from which the ten types of iron core were fabricated was measured to investigate the relationship between the residual magnetic flux density and the current ratio described above. The measurement conditions were such that 36 samples that were each 30 mm × 280 mm were cut out from the grain-oriented electrical steel sheet coils used to fabricate the iron cores. The excitation conditions were a frequency of 50 Hz and a magnetic flux density of 1.70 T and 1.50 T. (Hereinafter, 50 Hz/1.50 T means that the excitation conditions were a frequency of 50 Hz and a magnetic flux density of 1.50 T.)

Typically, a magnetic flux density of 1.70 T is used to evaluate the properties of grain-oriented electrical steel sheets, but at high magnetic fields, the effect of crystal orientation on the flow of magnetization is greater, and therefore the strain effect suggested by the previous results is difficult to reflect. Accordingly, the magnetic flux density of 1.50 T was also evaluated, which was considered to be less affected by crystal orientation and more likely to reflect the effect of strain.

Further, the residual magnetic flux density of the grain-oriented electrical steel sheets used in each iron core was set according to the two conditions indicated below.

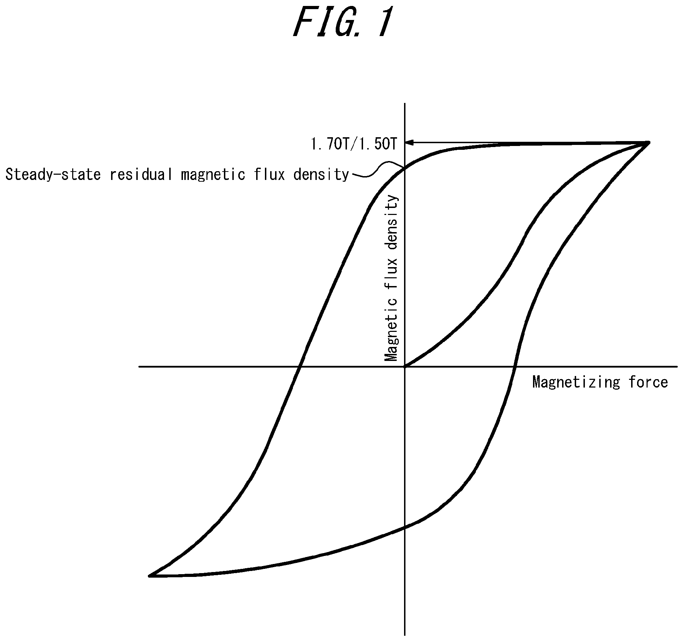

The first was that the residual magnetic flux density was determined as magnetic flux density at zero magnetizing force in the AC hysteresis curve during AC excitation (see FIG. 1). Hereinafter, such magnetic flux density at zero magnetizing force is denoted as steady-state residual magnetic flux density.

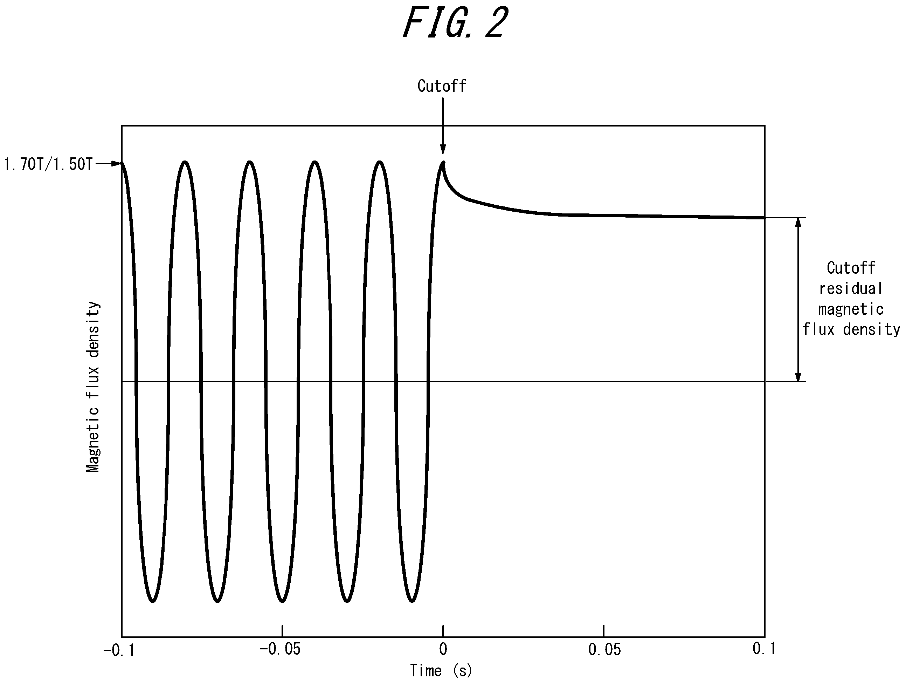

The second was that the residual magnetic flux density was determined by cutting off power supply when the magnetic flux reached maximum, and is magnetic flux density at 0.1 s after the power supply was cut off, when magnetic flux density change saturated (see FIG. 2). Hereinafter, the magnetic flux density at 0.1 s from the time of such cutoff is denoted specifically as cutoff residual magnetic flux density Br.

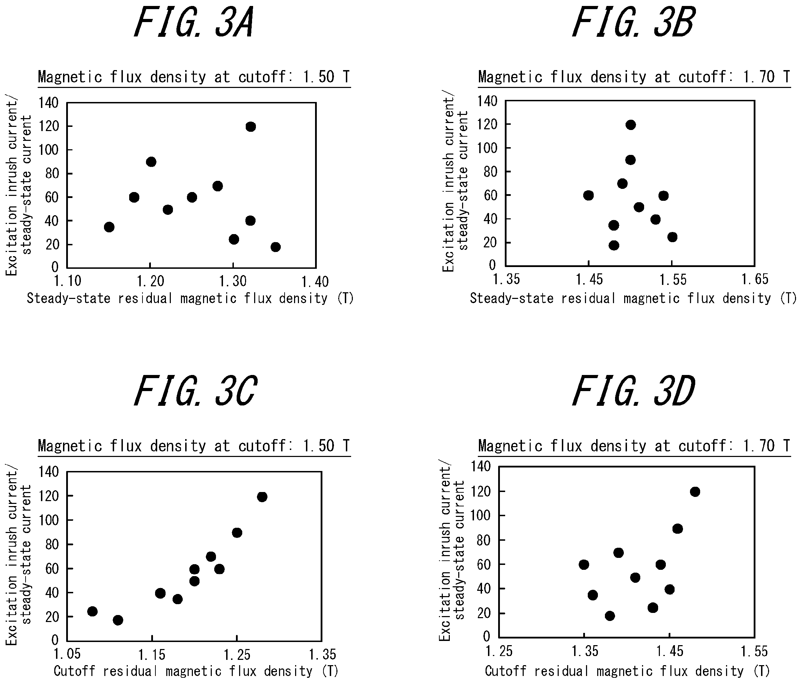

The relationships between each residual magnetic flux density and ratio of excitation inrush current to steady-state current (hereinafter also referred to as current ratio) are illustrated in FIG. 3A to FIG. 3D. As illustrated in FIG. 3A and FIG. 3B, no significant correlation was observed between steady-state residual magnetic flux density and current ratio. On the other hand, as illustrated in FIG. 3C and FIG. 3D, a particularly good correlation was found between current ratio and cutoff magnetic flux density measured 0.1 s after current was cut off when the current reached 1.50 T, that is, the cutoff residual magnetic flux density Br. Magnetic flux density cut off at 1.50 T is illustrated in FIG. 3A and FIG. 3C and at 1.70 T is illustrated in FIG. 3B and FIG. 3D.

The reason why no correlation was observed in the steady-state residual magnetic flux density is not clear, but may be due to the large difference between magnetic flux behavior at cutoff and that at steady state.

From the above, it is clear that in order to evaluate material capable of suppressing excitation inrush current, it is very important to determine residual magnetic flux at cutoff, which is an actual cause of excitation inrush current, at low magnetic fields (1.50 T) with high strain sensitivity.

From the data illustrated in FIG. 3C, it can be seen that the cutoff residual magnetic flux density Br varies by changing typical control factors during laser irradiation: I) output, II) deflection speed, and III) beam diameter. Therefore, by searching for optimum laser irradiation conditions using the cutoff residual magnetic flux density Br as an evaluation index, it is possible to suppress excitation inrush current to some extent.

However, in the above study, the inventors also found that the combination of normal laser irradiation conditions alone had an insufficient suppression effect on excitation inrush current. Therefore, the inventors investigated measures to further decrease the cutoff residual magnetic flux density Br.

Here, quality within the laser was considered.

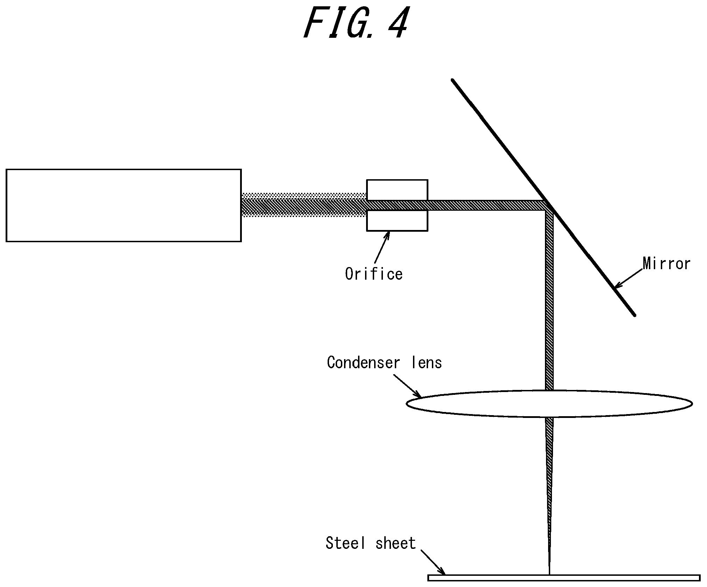

The intensity of the laser emitted from an oscillator at a given output is not uniform within the laser, with higher intensity in the center, which is considered good laser quality. Accordingly, the effects of laser quality on the cutoff residual magnetic flux density Br and excitation inrush current were investigated. As a means of modifying laser quality, an orifice was set in the laser path to eliminate the outer periphery of the laser (where quality was considered poor), and the laser was then focused and irradiated onto a steel sheet (see FIG. 4). That is, quality of a focused laser was varied by changing the orifice diameter that eliminates portions of the laser.

In the investigation described above, the smaller the orifice diameter, the greater the amount of laser eliminated from the periphery, thereby performing irradiation with a laser considered to be of higher quality.

In this investigation, laser irradiation was first performed on laser alignment paper (burn paper) under the same conditions both before and after the orifice was installed, and the beam diameter and a range cut by the orifice were checked. Burn paper is thermal paper that discolors only where irradiated by a laser.

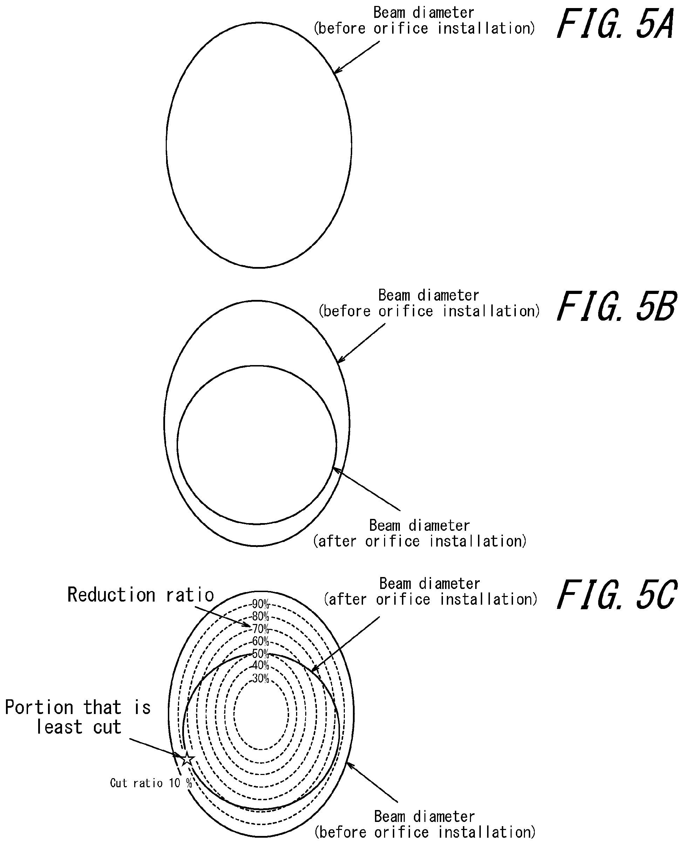

FIG. 5A to FIG. 5C illustrate a peripheral beam cut ratio, as defined by the present disclosure. First, beam shape is measured before the orifice is installed (FIG. 5A). After transferring the shape onto a new burn paper, an orifice is installed, and the laser is irradiated onto the burn paper with the beam diameter recorded before the orifice was installed (FIG. 5B). The next step is to identify a portion with the least periphery cut and derive the ratio of that portion cut (FIG. 5C). This minimum beam cut ratio is defined as a periphery elimination ratio.

As an example, based on the irradiation conditions of the coil from which transformer No. 6 was fabricated, strain was introduced into the steel sheet, changing only the orifice diameter. In order to keep the laser intensity introduced into the steel sheet the same, laser output was varied to match transmittance. Specifically, when laser transmittance was 50 %, the laser output was doubled to introduce strain.

Transmittance was measured by using a camera-type beam profiler to measure light intensity received at each pixel of the digital camera, and transmittance was set as the ratio of the sum of the beam intensity after orifice installation to the sum of the beam intensity before orifice installation (= sum of beam intensity after orifice installation / sum of beam intensity before orifice installation). The beam intensity measured here is not the beam that reaches the steel sheet surface, but the beam immediately after passing through the orifice.

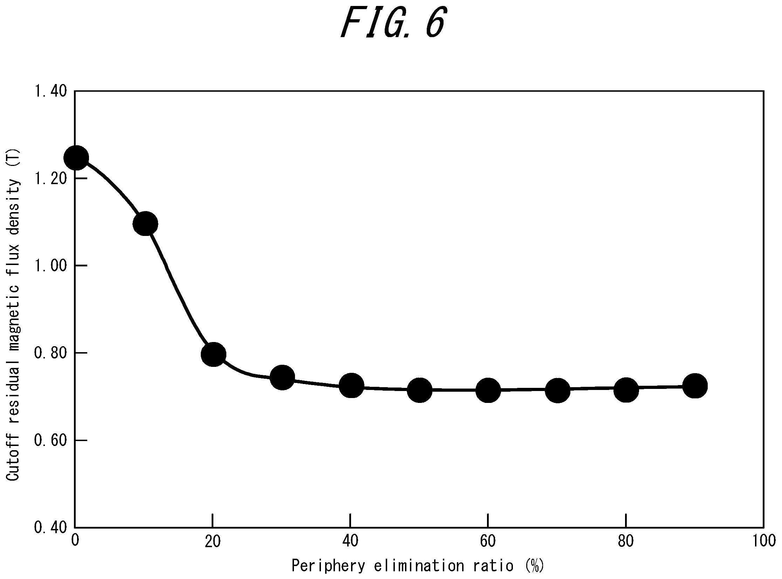

FIG. 6 illustrates the relationship between the periphery elimination ratio and the cutoff residual magnetic flux density Br (50 Hz/1.50 T). It was found that the cutoff residual magnetic flux density Br decreases significantly as the periphery elimination ratio increases. In particular, it was found that the effect of decreasing cutoff residual magnetic flux density Br due to laser quality improvement was stably obtained when the periphery elimination ratio was 20 % or more.

The cause of the decrease in cutoff residual magnetic flux density Br is not clear, but may be the result of improved laser quality, which improves laser convergence and steel sheet penetration, and significantly changes the strain distribution introduced.

Next, the cutoff residual magnetic flux density Br was varied by changing the periphery elimination ratio according to the orifice diameter, and the relationship between the cutoff residual magnetic flux density Br and excitation inrush current was investigated. For this investigation, as an example, based on the irradiation conditions of the coil from which transformer No. 4 was fabricated, laser output was varied according to transmittance so that the laser intensity introduced into the steel sheet would be the same, as described above. The transformers for evaluation were of the same type as listed in Table 1.

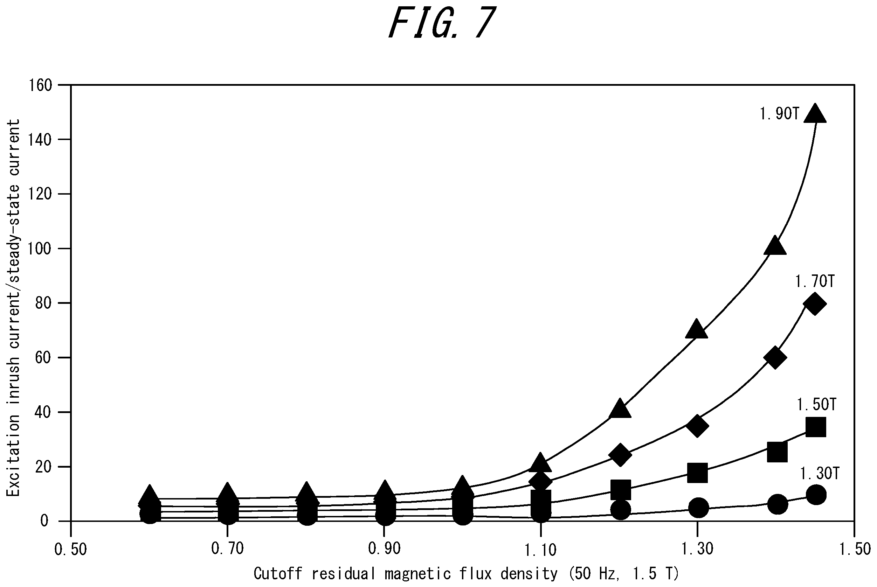

FIG. 7 illustrates the relationship between the cutoff residual magnetic flux density (50 Hz/1.50 T) and excitation inrush current/steady-state current (current ratio). Excitation magnetic flux density was varied from 1.30 T to 1.90 T. As mentioned above, in transformers using steel sheets having a cutoff residual magnetic flux density Br of 1.00 T or less, determined at 1.50 T, it is clear that the occurrence of excitation inrush current is suppressed under all conditions.

The periphery elimination by the installation of an orifice is an important point of the present disclosure, but even with the same orifice, the quality of the transmitted beam differs depending on misalignment of installation position and the like. For example, when the beam center and orifice center coincide, the beam near the center is transmitted, but when the centers are misaligned, the beam that is off-center is transmitted.

The inventors suspected that such differences in transmitted beam quality might also have a significant effect, and investigated the relationship between intensity distribution in the transmitted beam and the cutoff residual magnetic flux density Br.

The intensity distribution in the transmitted beam was varied by changing the center positions of the orifice and the beam. The maximum intensity in the beam was used to normalize, and the difference between the maximum intensity ratio and the minimum intensity ratio was used as a beam quality variation evaluation factor. Under each condition, the periphery elimination ratio was always 20 % or more.

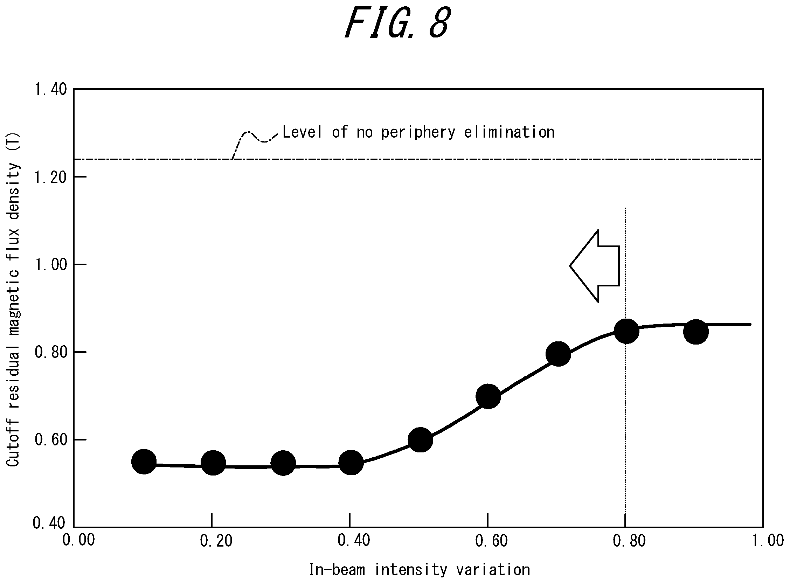

FIG. 8 illustrates the relationship between the variation of beam intensity in the transmitted beam and the cutoff residual magnetic flux density Br (50 Hz/1.50 T). The cutoff residual magnetic flux density Br was found to decrease significantly as the variation of beam intensity in the transmitted beam decreases. In particular, it can be seen that the effect of decreasing the cutoff residual magnetic flux density Br is obtained more when the variation of beam intensity is controlled to be 0.80 or less. To obtain such an effect consistently, the variation of beam intensity is more preferably 0.50 or less.

The in-beam intensity variation is derived by measuring the in-beam intensity distribution using a commercially available beam profiler, determining the intensity ratio of each measurement point to the maximum intensity of all measurement points (beam intensity normalization), and determining the difference between the maximum intensity ratio and the minimum intensity ratio. The intensity measurement method is not particularly limited, and examples include a method of irradiating a laser beam onto a fluorescent plate, separating the fluorescence by a wavelength-separating mirror, and forming a fluorescent image on a light-receiving surface inside a camera, and other methods. According to the present disclosure, the intensity distribution in the laser was measured using the BPF series of beam profilers for high-output lasers produced by Canare Electric Co., Ltd.

Although the above investigation was conducted with a laser, it was also found that the same effect is obtainable with an electron beam by selecting the conditions. Hereinafter, when referring to a beam, in the present disclosure this means a high-energy beam, and specifically a laser, plasma, or electron beam.

The present disclosure is based on the above discoveries and primary features of the present disclosure are as follows.
1. A grain-oriented electrical steel sheet subjected to magnetic domain refining by strain introduced from at least one surface of the steel sheet to the interior of the steel sheet, linearly so as to intersect the steel sheet rolling direction, the grain-oriented electrical steel sheet having a cutoff residual magnetic flux density Br of 1.00 T or less,
   wherein
   the cutoff residual magnetic flux density Br is magnetic flux density when magnetization that changes with a sine wave of 50 Hz is generated in the rolling direction of the grain-oriented electrical steel sheet, power supply is cut off when the magnetization reaches 1.50 T, and the magnetic flux density is measured 0.1 s after the power supply is cut off.
2. A method of producing the grain-oriented electrical steel sheet according to 1, above, wherein when a surface of the steel sheet that has undergone final annealing is irradiated with a high-energy beam to undergo magnetic domain refining treatment, an orifice is disposed in the path of the high-energy beam to eliminate a periphery of the high-energy beam, which is then focused to introduce strain into the steel sheet and decrease cutoff residual magnetic flux density Br to 1.00 T or less,
   wherein
   the cutoff residual magnetic flux density Br is magnetic flux density when magnetization that changes with a sine wave of 50 Hz is generated in the rolling direction of the grain-oriented electrical steel sheet, power supply is cut off when the magnetization reaches 1.50 T, and the magnetic flux density is measured 0.1 s after the power supply is cut off.
3. The method of producing the grain-oriented electrical steel sheet according to 2, above, wherein variation of beam intensity in the beam after the periphery is eliminated is 0.80 or less.
4. An iron core for a transformer formed using the grain-oriented electrical steel sheet according to 1, above.

### (Advantageous Effect)

The present disclosure makes it possible to provide a grain-oriented electrical steel sheet that can suppress the generation of excitation inrush current when used as transformer iron core material.

### BRIEF DESCRIPTION OF THE DRAWINGS

In the accompanying drawings:
FIG. 1 is a diagram illustrating an AC hysteresis curve during AC excitation;
FIG. 2 is a graph illustrating time variation of magnetic flux density, illustrating power supply being cut off when magnetic flux is at maximum and magnetic flux density after 0.1 s from the cutoff when magnetic flux density variation saturates;
FIG. 3A and FIG. 3B are diagrams illustrating the relationship between steady-state residual magnetic flux density and excitation inrush current/steady-state current (current ratio), and FIG. 3C and FIG. 3D are diagrams illustrating the relationship between cutoff residual magnetic flux density and excitation inrush current/steady-state current (current ratio);
FIG. 4 is a schematic diagram illustrating how a laser is focused and irradiated onto a steel sheet after a periphery of the laser is eliminated by an orifice;
FIG. 5A to FIG. 5C are diagrams illustrating a procedure for determining periphery elimination ratio;
FIG. 6 is a diagram illustrating the relationship between periphery elimination ratio and cutoff residual magnetic flux density at 50 Hz/1.50 T;
FIG. 7 is a diagram illustrating the relationship between cutoff residual magnetic flux density and excitation inrush current/steady-state current (current ratio);
FIG. 8 is a diagram illustrating the relationship between in-beam intensity variation and cutoff residual magnetic flux density after periphery elimination; and
FIG. 9 is a diagram illustrating the rolling direction and transverse direction (orthogonal to rolling direction) of non-heat-resistant type magnetic domain-refined material.

### DETAILED DESCRIPTION

The following is a description of constituent elements according to the present disclosure.

In the grain-oriented electrical steel sheet according to the present disclosure, when power supply is cut off at a timing when magnetic flux density is maximum during AC excitation under the conditions of 50 Hz/1.50 T, the residual magnetic flux density in the steel sheet 0.1 s after the power is cut off, that is, the cutoff residual magnetic flux density Br, needs to be 1.00 T or less. That is, when the cutoff residual magnetic flux density Br exceeds 1.00 T, excitation inrush current becomes large, and such a large current, even though a momentary transient current, may cause equipment to malfunction, leading to large-scale trouble such as an emergency shutdown. The cutoff residual magnetic flux density Br is preferably 0.60 T or less. On the other hand, a lower limit is not particularly limited and may be 0.00 T. For industrial purposes, the lower limit is preferably about 0.10 T.

Further, prior to magnetic domain refining, methods of producing a grain-oriented electrical steel sheet for use according to the present disclosure are not particularly limited and known methods may be used. A method of producing a grain-oriented electrical steel sheet that can more suitably control the cutoff residual magnetic flux density Br is indicated below.

First, suitable basic components and optionally added components of steel material (a steel slab) for the production of the grain-oriented electrical steel sheet are described below.

For a chemical composition without use of inhibitors that limit the content of Al, N, S, and Se, the content of Al, N, S, and Se in the steel material is preferably controlled to Al: 100 mass ppm or less, N: 50 mass ppm or less, S: 50 mass ppm or less, and Se: 50 mass ppm or less.

On the other hand, as examples when an inhibitor is used, Al and N may be included in the steel material in appropriate amounts when an AlN inhibitor is used, or Mn and Se and/or S may be included in the steel material in appropriate amounts when a MnS/MnSe inhibitor is used. Of course, both inhibitors may be used together.

When using these inhibitors, suitable content of Al, N, S, and Se in the steel material is Al: 0.01 mass% to 0.065 mass%, N: 0.005 mass% to 0.012 mass%, S: 0.005 mass% to 0.03 mass%, and Se: 0.005 mass% to 0.03 mass%.

### C: 0.08 mass% or less

C is added to improve hot-rolled sheet microstructure, but when content exceeds 0.08 mass%, it becomes difficult to decrease C content during the production process to 50 mass ppm or less where magnetic aging does not occur. The C content is therefore preferably 0.08 mass% or less. A lower limit of C content does not need to be specified since secondary recrystallization is possible even with material that does not contain C. From the viewpoint of improving hot-rolled sheet microstructure, 0.01 mass% or more is preferred.

### Si: 2.0 mass% to 8.0 mass%

Si is an element effective in enhancing steel electrical resistance and decreasing iron loss. When Si content is less than 2.0 mass%, a sufficient iron loss reduction effect may not be achieved. On the other hand, when the Si content exceeds 8.0 mass%, workability significantly decreases and magnetic flux density also decreases. The Si content is therefore preferably in a range from 2.0 mass% to 8.0 mass%. The Si content is more preferably 2.0 mass% or more. Further, the Si content is more preferably 4.0 mass% or less.

### Mn: 0.005 mass% to 1.0 mass%

Mn is an element required to improve hot workability. However, when content is less than 0.005 mass%, the effect of addition is poor. On the other hand, when the Mn content exceeds 1.0 mass%, magnetic flux density of a product sheet decreases. The Mn content is therefore preferably in a range from 0.005 mass% to 1.0 mass%. The Mn content is more preferably 0.01 mass% or more. Further, the Mn content is more preferably 0.1 mass% or less.

In addition to the basic components listed above, one or more of the following elements may be included as a magnetic property improving component (optionally added component).

Ni: 0.03 mass% to 1.50 mass%, Sn: 0.01 mass% to 1.50 mass%, Sb: 0.005 mass% to 1.50 mass%, Cu: 0.03 mass% to 3.0 mass%, P: 0.03 mass% to 0.50 mass%, Mo: 0.005 mass% to 0.10 mass%, and Cr: 0.03 mass% to 1.50 mass%.

### Ni: 0.03 mass% to 1.50 mass%

Ni is a useful element for improving hot-rolled sheet microstructure and improving magnetic properties. However, when content is less than 0.03 mass%, the effect of improving magnetic properties is small. On the other hand, when the Ni content exceeds 1.50 mass%, secondary recrystallization may become unstable and magnetic properties may degrade. Therefore, when Ni is contained, the content is preferably in the range from 0.03 mass% to 1.50 mass%.

Further, although Sn, Sb, Cu, P, Mo, and Cr are each a useful element for improving magnetic properties, they each have little effect on improving magnetic properties when the lower limit described above is not met. On the other hand, when the upper limit for each component described above is exceeded, development of secondary recrystallized grains is inhibited. Therefore, when at least one of Sn, Sb, Cu, P, Mo, or Cr is included, the content thereof is preferably in the corresponding range described above.

The balance other than the components described above is Fe and inevitable impurity mixed in during the production process. That is, in the steel material according to the present disclosure, the balance other than the above components is Fe and inevitable impurity.

However, in the grain-oriented electrical steel sheet, C is decarburized in primary recrystallization annealing, and Al, N, S, and Se are purified in final annealing, and therefore Al is decreased to 0.01 mass% or less and C, N, S, and Se are each decreased to 0.005 mass% or less in the steel sheet after final annealing (product sheet).

The steel material having the chemical composition described above can then be heated and hot rolled according to a conventional method. Alternatively, for example, the steel material cast into a slab may be immediately hot rolled without heating. In the case of a thin slab or thinner cast steel, the thin slab or thinner cast steel may be hot rolled or may directly proceed to subsequent processing, omitting hot rolling.

Further, in order to improve magnetic properties of the steel sheet, hot-rolled sheet annealing is carried out as required. For high development of Goss texture in the product sheet, the hot-rolled sheet annealing temperature is preferably in a range from 800 °C to 1100 °C. When the hot-rolled sheet annealing temperature is less than 800 °C, band texture in the hot rolling may remain, which may make it difficult to realize primary recrystallized texture having uniformly-sized grains and may inhibit development of secondary recrystallization. On the other hand, when the hot-rolled sheet annealing temperature is more than 1100 °C, grain size after the hot-rolled sheet annealing may become excessively coarse, which may make it difficult to realize primary recrystallized texture having uniformly-sized grains.

The thin slab or thinner cast steel, or the steel sheet after hot rolling or after hot-rolled sheet annealing is then subjected to cold rolling once or two or more times with intermediate annealing in between. After decarburization annealing, an annealing separator is applied and final annealing is applied for secondary recrystallization and formation of forsterite film. After the final annealing, it is effective to subject the sheet to flattening annealing for shape adjustment. According to the present disclosure, an insulating coating is preferably formed on the steel sheet surface before or after the flattening annealing.

The insulating coating according to the present disclosure is a coating capable of imparting tension to the steel sheet in order to decrease iron loss (hereinafter, also referred to as "tension coating"). Examples of tension coating include inorganic coating containing silica and ceramic coating applied by physical vapor deposition, chemical vapor deposition, and the like.

At least one of the surfaces of the steel sheet obtained in this way is irradiated with a beam to further decrease iron loss, introducing strain into the steel sheet.

As described above, according to the present disclosure, the quality of the beam has been found to significantly affect the cutoff residual magnetic flux density Br, and therefore it is essential to position an orifice to eliminate a portion of the beam that has low intensity (considered to be of poor quality) between the beam being emitted from the light source of the beam and the beam being focused.

Hereinafter, orifice means a component that effectively extracts a central portion of the beam. The configuration of the orifice is not particularly limited as long as the aforementioned purpose can be achieved, but when a plate with a hole smaller than the diameter of the beam is installed as described above, the purpose may be realized.

Such treatment makes it possible to more simply and stably control the cutoff residual magnetic flux density Br to be in the range of the present disclosure. To even more stably control the cutoff residual magnetic flux density Br within the range of the present disclosure, the orifice installation conditions are preferably controlled so that the periphery elimination ratio is 10 % or more. The periphery elimination ratio is more preferably 20 % or more. The periphery elimination ratio is even more preferably 25 % or more. On the other hand, the periphery elimination ratio is preferably 50 % or less.

In addition, decreasing in-beam intensity variation after passing through the orifice and improving the beam quality are also effective in further decreasing the cutoff residual magnetic flux density Br. Variation of beam intensity is preferably 0.80 or less. Variation of beam intensity is more preferably 0.70 or less. Variation of beam intensity is even more preferably 0.50 or less. On the other hand, a lower limit of variation of beam intensity is not particularly limited and may be 0.00. In terms of production control, variation of beam intensity is preferably about 0.10.

The amount of the beam reaching the steel sheet is decreased by elimination of the periphery of the beam, and therefore there is a concern that iron loss, which is a basic property of a grain-oriented electrical steel sheet, may degrade. However, such a concern may be addressed by adjusting the output of the initial beam when refining the magnetic domain of the steel sheet.

Conditions for magnetic domain refining not mentioned above are not particularly limited and treatment under known conditions may be carried out, for example.

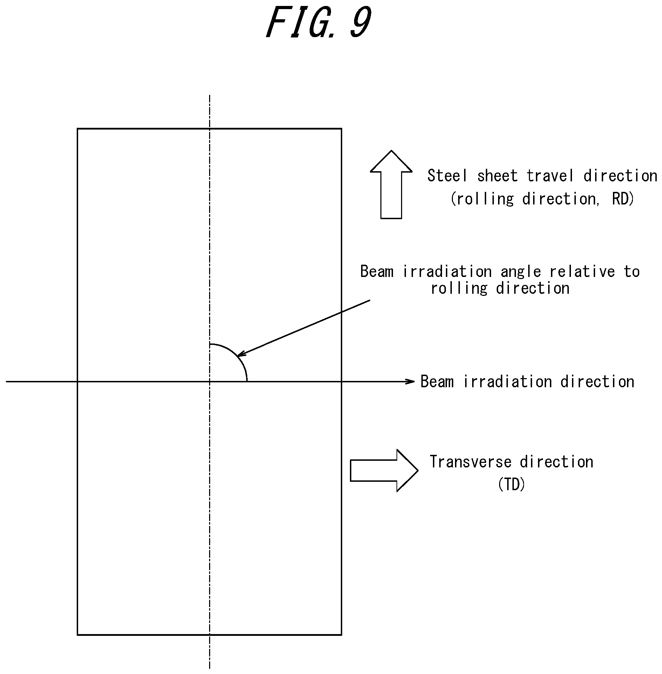

For example, the direction of irradiation of the beam (the direction in which the closure domain formed by the irradiation extends) is across the rolling direction (longitudinal direction, RD in FIG. 9) of the non-heat-resistant type magnetic domain-refined material, suitably at an angle of 60° to 90° to the rolling direction. The 90° direction described above corresponds to the transverse direction (TD in FIG. 9). Further, for example, the output of laser beam irradiation is preferably from 100 W to 8 kW. Further, from the viewpoint of productivity, laser beam deflection speed is preferably 10 m/s or more. Similarly, the output of electron beam irradiation is preferably 50 W to 5 kW. Further, from the viewpoint of productivity, electron beam deflection speed is preferably 10 m/s or more. Laser beams and electron beams have different steel sheet energy absorption efficiencies, and therefore have different preferred ranges of output, as described above.

Depending on the combination of treatment conditions described above (known magnetic domain refining treatment conditions and orifice conditions), there may be conditions under which the cutoff residual magnetic flux density Br does not become 1.00 T or less, and therefore it is necessary to use an optimal combination of conditions explored in advance.

There is no particular limitation on wire spacing for the purpose of decreasing the cutoff residual magnetic flux density Br. For the purpose of decreasing iron loss, which is a basic property of grain-oriented electrical steel sheets, as much as possible, the wire spacing in the longitudinal direction is preferably more than 3.0 mm. The wire spacing in the longitudinal direction is preferably less than 8.0 mm. Further, the beam, from which the periphery is eliminated by the orifice, is focused and reaches the steel sheet. From the viewpoint of low iron loss, the beam diameter is preferably 0.20 mm or less upon reaching the steel sheet. On the other hand, a lower limit of the beam diameter is not particularly limited. In industrial terms, a lower limit of about 0.010 mm is preferred.

### EXAMPLES

The present disclosure is described in detail below, based on examples. The following examples merely represent preferred examples, and the present disclosure is not limited to these examples. Embodiments of the present disclosure may be modified as appropriate to an extent that conforms to the spirit of the present disclosure, and all such modifications are included within the technical scope of the present disclosure.

### (Examples 1)

Grain-oriented electrical steel sheets (final annealing completed) each having a thickness of 0.23 mm and the same magnetic flux density (B₈ = 1.92 T) were prepared and subjected to non-heat-resistant type magnetic domain refining treatment by laser or electron beam irradiation using an appropriate orifice. The respective irradiation conditions (means, output, deflection speed, beam diameter, irradiation line spacing, periphery elimination ratio, and beam intensity variation after periphery elimination) are listed in Table 2. The iron loss W_{17/50} and the cutoff residual magnetic flux density Br (50 Hz/1.50 T) of the grain-oriented electrical steel sheets subjected to non-heat-resistant type magnetic domain refining treatment were then derived. This data is also listed in Table 2.

Next, three-phase coil iron cores were fabricated using the grain-oriented electrical steel sheets subjected to the non-heat-resistant type magnetic domain refining treatment as the iron core material (iron cores including the grain-oriented electrical steel sheets). For each of the coil iron cores, mass was about 40 kg and capacity was 30 kVA.

The coil iron cores were either Unicore, with an overlapping portion in one flat section (one lap joined portion in one circuit) and bends at the corners, or duo core with overlapping portions in two flat sections (two lap joined portions in one circuit) and bends at the corners. The overlapping margin in one coil iron core was assumed to be constant. Further, the Unicores and duo cores were made by working grain-oriented electrical steel sheets to have 45° angles at the bends and then stacking to make coil iron cores.

The iron loss W_{17/50} and excitation inrush current (50 Hz/1.7 T) of the coil iron cores were measured. Power cutoff was carried out when the magnetic flux in the central leg (V leg) was at maximum (1.7 T), and power supply resumption was carried out when the phase was shifted 180° relative to the cutoff timing.

The iron loss W_{17/50} and the ratio of excitation inrush current to the steady-state current (current ratio) of the coil iron cores are listed together in Table 2. The current ratio here means (excitation inrush current/steady-state current).

[Table 2]

**Table 2**

| No. | Irradiation conditions | | | | | | | Grain-oriented electrical steel sheet | | Transformer | | | Remarks |
|---|---|---|---|---|---|---|---|---|---|---|---|---|---|
| | Means | Output [W] | Deflection rate [m/s] | Beam diameter [mm] | Line spacing [mm] | Periphery elimination ratio [%] | Beam intensity variation after periphery elimination | W_{17/50} [W/kg] | Cutoff residual magnetic flux density Br [T] | Transformer type | W_{17/50} [W/kg] | Current ratio | |
| 1 | Laser | 150 | 10 | 0.12 | 5 | 0^{(*1)} | - | 0.72 | 1.41 | Unicore | 0.86 | 40 | Comparative Example |
| 2 | | 150 | 10 | 0.12 | 5 | 0^{(*1)} | - | 0.72 | 1.41 | Duo core | 0.86 | 40 | Comparative Example |
| 3 | | 165 | 10 | 0.12 | 5 | 10 | 0.40 | 0.72 | 0.82 | Unicore | 0.86 | 20 | Example |
| 4 | | 200 | 10 | 0.12 | 5 | 25 | 0.85 | 0.72 | 0.72 | Unicore | 0.86 | 15 | Example |
| 5 | | 200 | 10 | 0.12 | 5 | 25 | 0.60 | 0.72 | 0.72 | Unicore | 0.86 | 8 | Example |
| 6 | | 200 | 10 | 0.12 | 5 | 25 | 0.40 | 0.72 | 0.72 | Unicore | 0.86 | 5 | Example |
| 7 | | 300 | 10 | 0.12 | 5 | 50 | 0.40 | 0.72 | 0.72 | Unicore | 0.86 | 5 | Example |
| 8 | | 300 | 10 | 0.12 | 5 | 50 | 0.40 | 0.72 | 0.72 | Duo core | 0.86 | 5 | Example |
| 9 | Electron beam | 800 | 80 | 0.15 | 3 | 0^{(*1)} | - | 0.68 | 1.35 | Unicore | 0.82 | 30 | Comparative Example |
| 10 | | 800 | 80 | 0.15 | 3 | 0^{(*1)} | - | 0.68 | 1.35 | Duo core | 0.82 | 30 | Comparative Example |
| 11 | | 900 | 80 | 0.15 | 3 | 10 | 0.40 | 0.68 | 0.75 | Unicore | 0.82 | 16 | Example |
| 12 | | 1050 | 80 | 0.15 | 3 | 25 | 0.85 | 0.68 | 0.65 | Unicore | 0.82 | 12 | Example |
| 13 | | 1050 | 80 | 0.15 | 3 | 25 | 0.60 | 0.68 | 0.65 | Unicore | 0.82 | 6 | Example |
| 14 | | 1050 | 80 | 0.15 | 3 | 25 | 0.40 | 0.68 | 0.65 | Unicore | 0.82 | 4 | Example |
| 15 | | 1600 | 80 | 0.15 | 3 | 50 | 0.40 | 0.68 | 0.65 | Duo core | 0.82 | 4 | Example |
| 16 | | 1600 | 80 | 0.15 | 3 | 50 | 0.40 | 0.68 | 0.65 | Unicore | 0.82 | 4 | Example |
| (*1) Without orifice | | | | | | | | | | | | | |

Table 2 indicates that in the iron cores using grain-oriented electrical steel sheets within the scope of the present disclosure, the grain-oriented electrical steel sheets each had the cutoff residual magnetic flux density Br of 1.00 T or less, and the current ratio, the ratio of the excitation inrush current to the steady-state current, was low, resulting in low excitation inrush current. Regarding iron loss, which is a basic property, the iron loss properties of the grain-oriented electrical steel sheets and the iron cores to which the present disclosure was applied were all at the same level as those to which the present disclosure was not applied, indicating that application of the present disclosure has no adverse effect on other important properties.

### (Examples 2)

Grain-oriented electrical steel sheets (final annealing completed) each having a thickness of 0.23 mm and the same magnetic flux density (B₈ = 1.92 T) were prepared and subjected to non-heat-resistant type magnetic domain refining treatment by laser or electron beam irradiation using an appropriate orifice. The respective irradiation conditions (means, output, deflection speed, beam diameter, irradiation line spacing, periphery elimination ratio, and beam intensity variation after periphery elimination) are listed in Table 3. The iron loss W_{17/50} and the cutoff residual magnetic flux density Br (50 Hz/1.50 T) of the grain-oriented electrical steel sheets subjected to non-heat-resistant type magnetic domain refining treatment were then derived. This data is also listed in Table 3.

Next, three-phase stacked iron cores (stacked cores) were fabricated using the grain-oriented electrical steel sheets subjected to the non-heat-resistant type magnetic domain refining treatment as the iron core material (iron cores including the grain-oriented electrical steel sheets). For each iron core, overall width was 890 mm, depth was 800 mm, stacked thickness was 250 mm, iron core mass was about 1.0 t, and capacity was 2000 kVA. The joining method was a step lap method.

The iron loss W_{17/50} and excitation inrush current (50 Hz/1.70 T) of the stacked iron cores were measured. Power cutoff was carried out when the magnetic flux in the central leg (V leg) was at maximum (1.70 T), and power supply resumption was carried out when the phase was shifted 180° relative to the cutoff time.

The iron loss W_{17/50} and the ratio of excitation inrush current to the steady-state current (current ratio) of the stacked iron cores are listed together in Table 3. The current ratio here means (excitation inrush current/steady-state current).

**Table 3**

| No. | Irradiation conditions | | | | | | | Grain-oriented electrical steel sheet | | Transformer | | | Remarks |
|---|---|---|---|---|---|---|---|---|---|---|---|---|---|
| | Means | Output [W] | Deflection rate [m/s] | Beam diameter [mm] | Line spacing [mm] | Periphery elimination ratio [%] | Beam intensity variation after periphery elimination | W_{17/50} [W/kg] | Cutoff residual magnetic flux density Br [T] | Transformer type | W_{17/50} [W/kg] | Current ratio | |
| 1 | Laser | 150 | 10 | 0.12 | 5 | 0^{(*1)} | - | 0.72 | 1.41 | Stacked core | 1.01 | 50 | Comparative Example |
| 2 | | 165 | 10 | 0.12 | 5 | 10 | 0.30 | 0.72 | 0.81 | | 1.01 | 20 | Example |
| 3 | | 200 | 10 | 0.12 | 5 | 25 | 0.30 | 0.72 | 0.71 | | 1.01 | 8 | Example |
| 4 | | 300 | 10 | 0.12 | 5 | 50 | 0.85 | 0.72 | 0.71 | | 1.01 | 12 | Example |
| 5 | | 300 | 10 | 0.12 | 5 | 50 | 0.40 | 0.72 | 0.71 | | 1.01 | 8 | Example |
| 6 | Electron beam | 800 | 80 | 0.15 | 3 | 0^{(*1)} | - | 0.68 | 1.35 | | 0.95 | 60 | Comparative Example |
| 7 | | 900 | 80 | 0.15 | 3 | 10 | 0.30 | 0.68 | 0.75 | | 0.95 | 25 | Example |
| 8 | | 1050 | 80 | 0.15 | 3 | 25 | 0.30 | 0.68 | 0.65 | | 0.95 | 9 | Example |
| 9 | | 1050 | 80 | 0.15 | 3 | 25 | 0.85 | 0.68 | 0.65 | | 0.95 | 15 | Example |
| 10 | | 1600 | 80 | 0.15 | 3 | 50 | 0.40 | 0.68 | 0.65 | | 0.95 | 9 | Example |
| (*1) Without orifice | | | | | | | | | | | | | |

Table 3 indicates that in the iron cores using grain-oriented electrical steel sheets within the scope of the present disclosure, the grain-oriented electrical steel sheets each had the cutoff residual magnetic flux density Br of 1.00 T or less, and the current ratio, the ratio of the excitation inrush current to the steady-state current, was low, resulting in low excitation inrush current. Regarding iron loss, which is a basic property, the iron loss properties of the grain-oriented electrical steel sheets and the iron cores to which the present disclosure was applied were all at the same level as those to which the present disclosure was not applied, indicating that application of the present disclosure has no adverse effect on other important properties.

## Claims

1. A grain-oriented electrical steel sheet subjected to magnetic domain refining by strain introduced from at least one surface of the steel sheet to the interior of the steel sheet, linearly so as to intersect the steel sheet rolling direction,
the grain-oriented electrical steel sheet having a cutoff residual magnetic flux density Br of 1.00 T or less,
wherein
the cutoff residual magnetic flux density Br is magnetic flux density when magnetization that changes with a sine wave of 50 Hz is generated in the rolling direction of the grain-oriented electrical steel sheet, power supply is cut off when the magnetization reaches 1.50 T, and the magnetic flux density is measured 0.1 s after the power supply is cut off.

2. A method of producing the grain-oriented electrical steel sheet according to claim 1, wherein when a surface of the steel sheet that has undergone final annealing is irradiated with a high-energy beam to undergo magnetic domain refining treatment, an orifice is disposed in the path of the high-energy beam to eliminate a periphery of the high-energy beam, which is then focused to introduce strain into the steel sheet and decrease cutoff residual magnetic flux density Br to 1.00 T or less,
wherein
the cutoff residual magnetic flux density Br is magnetic flux density when magnetization that changes with a sine wave of 50 Hz is generated in the rolling direction of the grain-oriented electrical steel sheet, power supply is cut off when the magnetization reaches 1.50 T, and the magnetic flux density is measured 0.1 s after the power supply is cut off.

3. The method of producing the grain-oriented electrical steel sheet according to claim 2, wherein variation of beam intensity in the beam after the periphery is eliminated is 0.80 or less.

4. An iron core for a transformer formed using the grain-oriented electrical steel sheet according to claim 1.
